# EUROPÄISCHE PATENTSCHRIFT

(11) **EP 0 502 449 B1**
(45) Veröffentlichungstag und Bekanntmachung des Hinweises auf die Patenterteilung: **27.03.1996**
(21) Anmeldenummer: 92103512.7
(22) Anmeldetag: 29.02.1992
(51) Int. Cl.: H03D 7/16, H03B 21/02

(54) **Frequenzumsetzer**
Frequency converter
Convertisseur de fréquence

(30) Priorität: 04.03.1991 CH 651/91
(43) Veröffentlichungstag der Anmeldung: 09.09.1992
(73) Patentinhaber: SIEMENS-ALBIS AKTIENGESELLSCHAFT, CH-8047 Zürich (CH)
(72) Erfinder: Lauper, Alfred, CH-8912 Obfelden (CH); Mächler, Fritz, CH-8854 Siebnen (CH); Rieder, Daniel, CH-5412 Gebenstorf (CH)

(56) Entgegenhaltungen:
- GB-A- 625 358
- GB-A- 2 091 508
- US-A- 4 661 995
- PATENT ABSTRACTS OF JAPAN vol. 7, no. 99 (E-172)(1244) 27. April 1983 & JP-A-58 020 040

## Beschreibung

Die vorliegende Erfindung betrifft einen Frequenzumsetzer nach dem Oberbegriff des Patentanspruchs 1.

Frequenzumsetzer, die die Trägerfrequenz eines Signals in einen gewünschten Frequenzbereich verschieben können, sind aus dem Stand der Technik weitgehend bekannt. Aus der EP-OS 0 192 808, Fig.1 ist eine Radarsendeeinrichtung bekannt, in der ein moduliertes Signal (y) vor der Zuführung zur Sendeantenne (A) in einem Frequenzumsetzer (FU) vom Zwischen- in den Hochfrequenzbereich verschoben wird. Frequenzumsetzer werden z.B. auch in Sendestufen von Magnetresonanzgeräten verwendet, die Signale im Bereich der Larmorfrequenzen der zu messenden Isotope an eine Messspule abgeben. Derartige Sendestufen weisen dabei meistens mehrere Frequenzteiler sowie Misch- und Filterstufen auf, anhand denen die gewünschte Frequenz im direkten Frequenzsyntheseverfahren erzielt werden kann. Falls z.B. eine Mischstufe, deren erstem Eingang ein Signal mit einer Frequenz von 70 MHz zugeführt wird, ein Signal im Bereich von 80 - 150 MHz abgeben soll, so wird dem dem zweiten Eingang der Mischstufe z.B. ein Signal zugeführt, das sich im Bereich von 10 - 80 MHz variieren lässt. Dabei treten am Ausgang eines der Mischstufe nachgeschalteten Bandpassfilters, das Frequenzen im Bereich von 80 - 150 MHz passieren lässt, in diesem Bereich nebst den gewünschten Signalanteilen oft auch störende Mischprodukte auf. Zur Erzeugung eines Signals mit einer Frequenz von 90 MHz wird der Mischstufe z.B. nebst dem Signal der Frequenz von 70 MHz auch ein Signal der Frequenz von 20 MHz zugeführt. Das Bandpassfilter lässt dabei nebst dem Signalanteil von 90 MHz auch Mischprodukte mit Oberwellenanteilen des 20 MHz - Signals, d.h. Signale mit Frequenzen von 110 MHz und 130 MHz passieren. Diese störenden Signalanteile lassen sich in der Folge nur durch einen erheblichen, zusätzlichen Filteraufwand beseitigen.

Zur Unterdrückung von Störsignalen werden in der Funktechnik oft Abstimmungvorrichtungen verwendet, die mit zwei Zwischenfrequenzstufen versehen sind. Aus der GB-A-625 358 ist eine nach dem Super-Heterodyn-Prinzip arbeitende Abstimmvorrichtung bekannt, durch die Signale über einen breiten Frequenzbereich empfangen und in zwei Zwischenfrequenzstufen gefiltert werden können. Diese Abstimmvorrichtung weist zwei Oszillatoren auf, von denen der erste ein Signal mit variabler und der zweite ein Signal mit fester Frequenz abgibt. Der Oszillator mit fester Frequenz wird verwendet, um das Signal des variablen Oszillators und das Ausgangssignal der ersten Zwischenfrequenzstufe auf ein tieferes Niveau hinunterzumischen. Dadurch kann der variable Oszillator, der auf einem höheren Frequenzniveau mit einem entsprechend tiefen Frequenzwechselverhältnis arbeitet, mit einer einzigen variablen Kapazität realisiert werden. Instabilitäten der beiden Oszillatoren, die z.B. bei Änderungen der Umgebungstemperatur auftreten können, verursachen bei dieser Abstimmvorrichtung jedoch Frequenzschwankungen, wie sie insbesondere bei Messgeräten unerwünscht sind. Aus der GB-A-625 358 ist femer ein mit zwei nicht-variablen Oszillatoren versehener Frequenzumsetzer bekannt, der eine verbesserte Stabilität aufweist, jedoch nicht für die Erzeugung eines Ausgangssignals mit variabler Frequenz geeignet ist.

Der vorliegenden Erfindung liegt daher die Aufgabe zugrunde, einen stabilen Frequenzumsetzer zu schaffen, der die Frequenz bzw. die Trägerfrequenz eines Signals in einen frei wählbaren Frequenzbereich verschieben kann, ohne dass weitere, störende Signalanteile in diesem Frequenzbereich auftreten.

Diese Aufgabe wird durch die im kennzeichnenden Teil des Patentanspruchs 1 angegebenen Massnahmen gelöst. Vorteilhafte Ausgestaltungen der Erfindung sind in weiteren Ansprüchen angegeben.

Der erfindungsgemässe Frequenzumsetzer erlaubt die Umsetzung der Frequenz eines Eingangssignals in eine beliebige Frequenz eines vorgegebenen Frequenzbereiches, ohne dass innerhalb dieses Frequenzbereiches störende Signalanteile auftreten. Dabei ist der Aufwand zur Filterung der erzeugten Signale sehr klein. Ferner bestehen für einzelne zur Frequenzumsetzung benötigte Signale nur geringe Stabilitätsanforderungen.

Die Erfindung wird nachfolgend anhand einer Zeichnung beispielsweise näher erläutert. Dabei zeigt:
- Fig. 1: Einen erfindungsgemässen einstufigen Frequenzumsetzer
- Fig. 2: Einen erfindungsgemässen zweistufigen Frequenzumsetzer

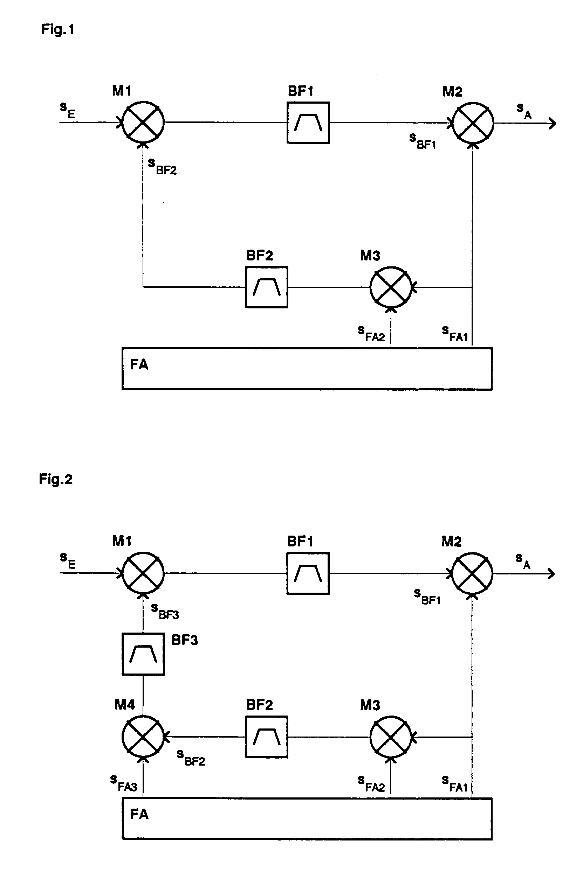

Fig. 1 zeigt einen Frequenzumsetzer, mit einer Mischstufe M1, deren erstem Eingang ein Eingangssignal s_{E} zugeführtwird und die überein Bandpassfilter BF1 mit einer weiteren Mischstufe M2 verbunden ist, die ein Ausgangssignal s_{A} abgibt. Ferner ist eine Mischstufe M3 vorgesehen, die über ein Bandpassfilter BF2 mit dem zweiten Eingang der Mischstufe M1 verbunden ist. Durch eine Frequenzaufbereitungsstufe FA wird ein erstes Signal s_{FA1} an die beiden Mischstufen M2, M3 und ein zweites Signal s_{FA2} an die Mischstufe M3 abgegeben. Die Frequenz des Eingangssignals s_{E} wird durch den Frequenzumsetzer in eine beliebige Frequenz innerhalb eines wählbaren Frequenzbereiches umgesetzt, ohne dass störende Oberwellen innerhalb dieses Frequenzbereiches entstehen. Zu diesem Zweck werden der Mischstufe M2 über das Bandfilter BF1 ein Signal s_{BF1} mit konstanter und von der Frequenzaufbereitungsstufe FA ein Signal s_{FA1} mit nach Wunsch variabler Frequenz zugeführt. Die Frequenzen der Signale s_{BF1} und s_{FA1} sind dabei derart gewählt, dass deren Differenz immer einer Frequenz innerhalb des gewählten Frequenzbereiches entspricht und deren Oberwellen immer ausserhalb des gewählten Frequenzbereiches liegen. Zur Erzeugung des Signals s_{BF1} wird das Eingangssignal s_{E} mit einem Signal s_{BF2} von konstanter Frequenz gemischt und durch das Bandfilter BF1 gefiltert. Das Signal s_{BF2} könnte nun eigentlich direkt durch die Frequenzaufbereitungsstufe FA erzeugt werden. In diesem Falle würden sich insbesondere Instabilitäten des Signals s_{FA1} direkt auf das Ausgangssignal s_{A} übertragen, da das Signal s_{FA1}, dessen Frequenz normalerweise sehr hoch und entsprechend einem gewählten Frequenzbereich variabel ist, oft nicht in der gewünschten Qualität erzeugt werden kann. Instabilitäten des Signals s_{FA1} sollen daher vollständig auskompensiert werden. Zur Erzeugung des Signals s_{BF2} wird daher das Signal s_{FA1} mit einem weiteren von der Frequenzaufbereitungsstufe FA erzeugten Signal s_{FA2} in der Mischstufe M3 gemischt und nachfolgend durch das Bandfilter BF2 gefiltert. Das Signal s_{FA2} ist dabei von tieferer Frequenz als das Signal s_{FA1}, jedoch um denselben Frequenzbereich variierbar. Durch die Subtraktion der Frequenzen der Signale s_{FA1} und s_{FA2} ergibt sich die konstante Frequenz des Signals s_{BF2}. Da das Signal s_{FA1} in den Mischstufen M2, M3 einmal addiert und einmal subtrahiert wird, heben sich Instabilitäten dieses Signals s_{FA1} gegenseitig auf. Durch die Wahl einer genügend grossen Bandbreite der Bandfilter BF1, BF2 wird dabei verhindert, dass insbesondere beim Umschalten der Frequenz Laufzeitverzögerungen auftreten, die eine vollständige gegenseite Kompensation der Anteile des Signals s_{FA1} verhindern. Das Signal s_{FA2}, das im Vergleich zum Signal s_{FA1} in einem tieferen Frequenzband liegt, kann ohne grösseren Aufwand mit einer hohen Qualität erzeugt werden. Instabilitäten, die beim Signal s_{FA2} auftreten und nicht auskompensiert werden, haben daher einen geringen Einfluss auf das Ausgangssignal s_{A}.

Das Eingangssignal s_{E} soll z.B. aus einer Folge von Pulsen bestehen, die einer Trägerfrequenz von 10 MHz aufmoduliert sind. Dabei soll die Trägerfrequenz in eine Frequenz im Bereich von 15 -65 MHz umgesetzt werden. Dazu werden die Frequenzen der der Mischstufe M3 zugeführten Signale s_{FA1}, s_{FA2} derart gewählt, dass sie jeweils im gleichen Frequenzabstand z.B. im Bereich von 100 - 150 MHz bzw. 25-75 MHz variierbar sind. Das von der Mischstufe M3 über das Bandfilter BF2 abgegebene Signal s_{BF2} weist daher die Differenzfrequenz der Frequenzen der beiden Signale s_{FA1}, s_{FA2} von konstant 75 MHz auf. Aus den in der Mischstufe M1 gemischten Signalen s_{E} und s_{BF2} wird durch das Bandfilter BF1 das Summensignal s_{BF1} herausgefiltert, das die Frequenz von 85 MHz aufweist und der Mischstufe M2 zugeführt wird. Der Mischstufe M2 wird daher ein Signal konstanter (s_{BF1} (85 MHz)) und ein Signal nach Wunsch variabler Frequenz (s_{FA1} (100 - 150 MHz)) zugeführt. Das von der Mischstufe M2 abgegebene Signal s_{A} enthält daher im Frequenzbereichvon 15-55 MHz jeweils nur eine durch Differenzbildung entstandene Frequenz. Das Signal s_{A} wird nachfolgend vorteilhafterweise einem Bandpassfilter zugeführt, das Signalanteile im Bereich von 15 - 65 MHz passieren lässt. Da die Signale s_{BF1}, s_{FA1} und deren Oberwellen nicht im Bereich von 15 - 85 MHz liegen, weist das Signal s_{A} in diesem Bereich eine hohe spektrale Reinheit auf. Die Frequenzen störender Signalanteile liegen dabei genügend weit ausserhalb des verwendeten Frequenzbereiches von 15 - 65 MHz und können daher leicht ausgefiltert werden.

In der Schaltungsanordnung gemäss Fig.2 wird das Ausgangssignal s_{BF2} des Bandfilters BF2 einer Mischstufe M4 zugeführt, der ferner ein von der Frequenzaufbereitungsstufe FA erzeugtes Signal s_{FA3} von konstanter Frequenz zugeführt wird. Das Ausgangssignal der Mischstufe M4 wird weiter über ein Bandpassfilter BF3 der Mischstufe M1 zugeführt. In dieser Schaltungsanordnung wird dieses mit dem Eingangssignal S_{E} in der Mischstufe M1 zu mischende Signal s_{BF3} in zwei Stufen erzeugt. Falls in Fig. 1 die Frequenzen der Signale s_{BF2}, s_{E}, s_{BF1}, s_{A} und s_{FA1} 320 MHz; 35 MHz; 285 MHz; 15 -85 MHz bzw. 300 - 370 MHz betragen würden, so müsste die Frequenz s_{FA2} im Bereichevon minus 20 MHz bis plus 50 MHz variierbar sein, damit nach der Differenzbildung mit dem Signal s_{FA1} (300 - 370 MHz) immer die konstante Frequenz von 320 MHz für das Signal s_{BF1} erzielt würde. Im Bereich um O MHz für das Signal s_{FA2} würden jedoch durch die Mischung dieses Signals am Ausgang der Mischstufe M2 Signalanteile entstehen, deren Frequenzen nahe bei 320 MHz liegen und das Bandpassfilter BF2 passieren würden. Durch die Schaltungsanordnung gemäss Fig. 2 wird die Frequenzumsetzung des Eingangssignals s_{E} in die gewünschten Frequenzbereiche daher vollzogen, ohne dass die Frequenz des Signals s_{FA2} in die Nähe von 0 MHz gerät. Die Erzeugung eines Signals mit konstant 320 MHz wird daher in zwei Schritten vorgenommen. Im ersten Schritt wird am Ausgang des Bandfilters BF2 ein Signal mit konstanter Frequenz erzeugt. Dies geschieht im vorliegenden Fall durch Mischung der Signale s_{FA1} und s_{FA2}, die beide um 70 MHz variierbar sind. Die untere Grenze des Frequenzbereichs für das Signal s_{FA2} wird bei 20 MHz gewählt, so dass der Abstand von Null immer genügend gross ist. Dabei ist natürlich zu berücksichtigen, dass die unterste Grenze des Frequenzbereichs für das Signal s_{FA2} jeweils im Zusammenhang mit der Bandbreite des Bandfilters BF2 festgelegt werden muss. D.h. mit grösserer Bandbreite soll ein grösserer Abstand von Null gewählt werden. Das am Ausgang des Bandfilters BF2 entstehende Signal s_{BF2} weist daher die konstante Frequenz von 280 MHz auf. In einem zweiten Schritt wird zur Erzeugung des gewünschten Signals von 320 MHz das Signal s_{BF2} (280 MHz) mit einem weiteren Signal entsprechender Frequenz gemischt und gefiltert. Das Signal s_{FA3}, das nebst dem Signal s_{BF2} der Mischstufe M4 zugeführt wird, weist eine Frequenz von 40 MHz auf, so dass das von der Mischstufe M4 abgegebene und durch das Bandfilter BF3 gefilterte Summensignal s_{BF3} die gewünschte Frequenz von 320 MHz erhält.

Die Erzeugung des Signals s_{FA1} kann aufgrund der geringen Stabilitätsanforderungen durch einfache Frequenzgeneratoren erfolgen, die z.B. einen phasengesteuerten Regelkreis oder nur einen spannungsgesteuerten Oszillator enthalten. Die Frequenz des Signals s_{FA2}, das durch einen hochwertigen Frequenzgenrator erzeugt wird, soll wie eingangs erläutert jeweils im gleichen Abstand zur Frequenz des Signals s_{FA1} gehalten werden.

## Patentansprüche

1. Frequenzumsetzer, der mindestens drei mit zwei Eingängen und einem Ausgang versehene Mischstufen (M1, M2, M3), mindestens zwei Bandpassfilter (BF1, BF2) und eine zur Abgabe von wenigstens zwei Signalen s_{FA1}, s_{FA2} vorgesehene Frequenzaufbereitungsstufe (FA) aufweist und der zur Abgabe eines Ausgangssignals sA vorgesehen ist, dessen Frequenz relativ zur Frequenz eines Eingangssignals s_{E} verschiebbar ist, das einem Eingang der ersten Mischstufe (M1) geführt wird, deren Ausgang über ein erstes Bandpassfilter (BF1) mit einem Eingang der zweiten Mischstufe (M2) verbunden ist, die das Ausgangssignal s_{A} abgibt, **dadurch gekennzeichnet,** dass die Frequenzaufbereitungsstufe (FA) das erste Signal s_{FA2} an einen Eingang der dritten Mischstufe (M3) und das zweite Signal s_{FA1} an die weiteren Eingänge der zweiten und dritten Mischstufe (M2, M3) abgibt, dass der Ausgang der dritten Mischstufe (M3) über ein zweites Bandpassfilter (BF2) mit dem weiteren Eingang der ersten Mischstufe (M1) verbunden ist und dass die Frequenzen der beiden Signale (s_{FA1}, s_{FA2} veränderbar sind und immer einen annähernd konstanten Frequenzabstand zueinander aufweisen.

2. Schaltungsanordnung nach Anspruch 1, **dadurch gekennzeichnet,** dass Signalanteile an den Ausgängen der zweiten und dritten Mischstufe (M2, M3) derart zur Weiterverarbeitung ausgewählt sind, dass die Frequenz des zweiten Signals s_{FA1}, das der zweiten und dritten Mischstufe (M2, M3) zugeführt wird, relativ zur Frequenz des Ausgangssignals s_{A} einmal addiert und einmal subtrahiert wird.

3. Schaltungsanordnung nach Anspruch 1 oder 2, **dadurch gekennzeichnet,** dass die Bandbreite des zweiten Bandfilters (BF2) und die tiefste Frequenz des ersten Signals s_{FA2} derart gewählt sind, dass unerwünschte Mischprodukte, die durch Mischung der beiden Signale s_{FA1}, s_{FA2} am Ausgang der dritten Mischstufe (M3) enstehen, durch das zweite Bandfilter (BF2) gesperrt werden.

4. Schaltungsanordnung nach Anspruch 3, **dadurch gekennzeichnet,** dass das zweite Bandpassfilter (BF2) über eine vierte Mischstufe (M4) und vorzugsweise ein dieser vierten Mischstufe (M4) nachgeschaltetes drittes Bandpassfilter (BF3) mit der ersten Mischstufe (M1) verbunden ist, dass der vierten Mischstufe (M4) durch die Frequenzaufbereitungsstufe (FA) ein drittes Signal s_{FA3} zuführbar ist, dessen Frequenz entsprechend dem Wert gewählt ist, um den die Frequenz des Signals s_{FA2} zu hoch gewählt wurde, um nicht zu nahe bei Null zu sein, so dass sich am Ausgang der vierten Mischstufe (M4) ein Signalanteil mit der ursprünglich gewünschten Frequenz ergibt.

5. Schaltungsanordnung nach Anspruch 1, 2, 3 oder 4, **dadurch gekennzeichnet,** dass zur Erzeugung des zweiten Signals (s_{FA1}) ein spannungsgesteuerter Oszillator (VCO) vorgesehen ist, der vorzugsweise in einen phasengesteuerten Regelkreis (PLL) eingeschlossen ist.

## Claims

1. Frequency converter which has at least three mixer stages (M1, M2, M3) provided with two inputs and one output, at least two band-pass filters (BF1, BF2) and a frequency-processing stage (FA) provided to deliver at least two signals S_{FA1}, S_{FA2}, and which is provided to deliver an output signal s_{A}, the frequency of which can be shifted relative to the frequency of an input signal s_{E} directed to an input of the first mixer stage (M1), the output of which is connected, by way of a first band-pass filter (BF1), to an input of the second mixer stage (M2) which delivers the output signal s_{A}, characterised in that the frequency-processing stage (FA) delivers the first signal S_{FA2} to an input of the third mixer stage (M3) and delivers the second signal S_{FA1} to the further input of the second mixer stage (M2) and to the further input of the third mixer stage (M3), in that the output of the third mixer stage (M3) is connected, by way of a second band-pass filter (BF2), to the further input of the first mixer stage (M1) and in that the frequencies of the two signals S_{FA1}, S_{FA2} can be varied and their frequency spacing relative to each other is always substantially constant.

2. Circuit arrangement according to claim 1, characterised in that signal components at the output of the second mixer stage (M2) and at the output of the third mixer stage (M3) are selected for further processing in such a way that the frequency of the second signal S_{FA1}, which is supplied to the second mixer stage (M2) and the third mixer stage (M3), is added once and is subtracted once relative to the frequency of the output signal s_{A}.

3. Circuit arrangement according to claim 1 or 2, characterised in that the band width of the second band filter (BF2) and the lowest frequency of the first signal s_{FA2} are chosen in such a way that undesirable mixed products, which develop at the output of the third mixer stage (M3) as a result of mixing the two signals s_{FA1}, s_{FA2}, are blocked by the second band filter (BF2).

4. Circuit arrangement according to claim 3, characterised in that the second band-pass filter (BF2) is connected to the first mixer stage (M1) by way of a fourth mixer stage (M4) and preferably a third band-pass filter (BF3) connected downstream of this fourth mixer stage (M4), in that a third signal s_{FA3} can be supplied to the fourth mixer stage (M4) by means of the frequency-processing stage (FA), the frequency of which third signal s_{FA3} is chosen in accordance with the value by which the chosen frequency of the signal s_{FA2} was too high in order not to be too close to zero so that a signal component with the originally desired frequency emerges at the output of the fourth mixer stage (M4).

5. Circuit arrangement according to claim 1, 2, 3 or 4, characterised in that a voltage-controlled oscillator (VCO), which is preferably contained in a phase-locked loop (PLL), is provided to generate the second signal (s_{FA1}).

## Revendications

1. Convertisseur de fréquence qui comporte au moins trois étages mélangeurs (M1,M2,M3), qui possèdent deux entrées et une sortie, au moins deux filtres passe-bande (BF1,BF2) et un étage de préparation de fréquences (FA) servant à délivrer au moins deux signaux s_{FA1}, s_{FA2}, et qui sert à délivrer un signal de sortie s_{A}, dont la fréquence peut être décalée par rapport à la fréquence d'un signal d'entrée s_{E}, qui est envoyé à l'entrée du premier étage mélangeur (M1), dont la sortie est reliée, par l'intermédiaire d'un premier filtre passe-bande (BF1), à une entrée d'un second étage mélangeur (M2), qui délivre le signal de sortie s_{A}, caractérisé par le fait que l'étage de préparation de fréquences (FA) délivre le premier signal s_{FA2} à une entrée du troisième étage mélangeur (M3) et le second signal s_{FA1} aux autres entrées des second et troisième étages mélangeurs (M2,M3), que la sortie du troisième étage mélangeur (M3) est reliée, par l'intermédiaire d'un second filtre passe-bande (BF2), à l'autre entrée du premier étage mélangeur (M1) et que les fréquences des deux signaux s_{FA1}, s_{FA2} peuvent être modifiées et que l'écart entre leurs fréquences est toujours approximativement constant.

2. Montage suivant la revendication 1, caractérisé par le fait que les composantes de signal présentes sur les sorties des second et troisième étages mélangeurs (M2,M3) sont sélectionnées pour la poursuite du traitement de telle sorte que la fréquence du second signal s_{FA1}, qui est envoyé aux second et troisième étages mélangeurs (M2,M3), est une fois ajoutée à et est une fois soustraite de la fréquence du signal de sortie s_{A}.

3. Montage suivant la revendication 1 ou 2, caractérisé par le fait que la largeur de bande du second filtre passe-bande (BF2) et la fréquence la plus basse du premier signal s_{FA2} sont choisies de telle sorte que des produits de mélange indésirables, qui apparaissent, par mélange des deux signaux s_{FA1}, s_{FA2}, à la sortie du troisième étage mélangeur (M3), sont bloqués par le second filtre passe-bande (BF2).

4. Montage suivant la revendication 3, caractérisé par le fait que le second filtre passe-bande (BF2) est relié, par l'intermédiaire d'un quatrième étage mélangeur (M4) et de préférence par l'intermédiaire d'un troisième filtre passe-bande (BF3) branché en aval de ce quatrième étage mélangeur (M4), au premier étage mélangeur (M1), qu'au quatrième étage mélangeur (M4) peut être envoyé, par l'étage de préparation de fréquences (FA), un troisième signal s_{FA3}, dont la fréquence est choisie en fonction de la valeur choisie pour augmenter la fréquence du signal s_{FA2}, pour qu'elle ne soit pas située trop près de zéro, de sorte qu'à la sortie du quatrième étage mélangeur (M4), on obtient une composante de signal possédant la fréquence initialement désirée.

5. Montage suivant la revendication 1, 2, 3 ou 4, caractérisé par le fait que pour la production du second signal (s_{FA1}), il est prévu un oscillateur commandé par la tension (VCO), qui est inséré de préférence dans un circuit de régulation commandé par la phase (PLL).
